Europäisches Patentamt

European Patent Office

Office européen des brevets

(19)

(11) EP 0 549 043 B1

(12) **FASCICULE DE BREVET EUROPEEN**

(45) Date de publication et mention
de la délivrance du brevet:
**30.10.1996 Bulletin 1996/44**

(51) Int Cl.6: **H03D 7/12**

(21) Numéro de dépôt: **92203927.6**

(22) Date de dépôt: **15.12.1992**

(54) **Circuit intégré comprenant un amplificateur à gain variable**

Integrierte Schaltung mit einem Verstärker mit variabler Verstärkung

Integrated circuit comprising an amplifier with variable gain

(84) Etats contractants désignés:
**DE FR GB IT**

(30) Priorité: **23.12.1991 FR 9116036**

(43) Date de publication de la demande:
**30.06.1993 Bulletin 1993/26**

(73) Titulaires:
• **LABORATOIRES D'ELECTRONIQUE PHILIPS
S.A.S.
94450 Limeil-Brévannes (FR)**
Etats contractants désignés:
**FR**
• **Philips Electronics N.V.
5621 BA Eindhoven (NL)**
Etats contractants désignés:
**DE GB IT**

(72) Inventeur: **Philippe, Pascal
F-75008 Paris (FR)**

(74) Mandataire: **Landousy, Christian et al
Société Civile S.P.I.D.
156, Boulevard Haussmann
75008 Paris (FR)**

(56) Documents cités:
**EP-A- 0 223 287        US-A- 3 609 412**

• **IEEE TRANSACTIONS ON MICROWAVE
THEORY AND TECHNIQUES, vol. 38, no. 9,
Septembre 1990, New York, US, pp. 1249-1251;
MICHELS et al.: 'A high-performance,
miniaturized X-band active mixer for DBS
receiver application with on-chip IF noise filter'**
• **PATENT ABSTRACTS OF JAPAN vol. 13, no. 453
(E-831) 11 Octobre 1989 & JP-A-1 175 304**
• **PATENT ABSTRACTS OF JAPAN vol. 12, no. 375
(E-666) 7 Octobre 1988 & JP-A-63 123 206**
• **PATENT ABSTRACTS OF JAPAN vol. 15, no. 102
(E-1043) 12 Mars 1991 & JP-A-2 308 607**

## Description

L'invention concerne un circuit intégré comprenant un amplificateur à gain variable ayant un premier transistor avec une charge montés en inverseur, commandé par un premier signal à une première fréquence, et ayant en outre une branche, formée d'une capacité en série avec un transistor monté en résistance variable, dont l'impédance est modulée par un second signal à une seconde fréquence.

L'invention trouve son application dans la réalisation de téléphones sans fil, de récepteurs pour automobile, ou de tout autre récepteur nécessitant des circuits à faible consommation, et d'un faible coût pour réalisation grand public. L'invention trouve aussi son application dans la réalisation de tout récepteur nécessitant un convertisseur de fréquences (en anglais Down-Converter) également appelé mélangeur en français.

Un tel mélangeur est déjà connu de la demande de brevet EP 0 223 287. Le circuit connu comprend un premier transistor à effet de champ dont la source est reliée à la masse, et dont le drain est relié à une charge active. Ces éléments forment un étage inverseur alimenté par une tension continue appliquée à travers la charge active. Le premier transistor reçoit sur sa grille un premier signal à une fréquence radio FR.

Ce circuit comprend en outre une branche formée d'un second transistor à effet de champ monté en résistance variable en série avec une capacité. Cette branche est montée entre la masse et le drain du premier transistor. Le second transistor monté en résistance variable est commandé par un second signal à une seconde fréquence OL provenant d'un oscillateur local. Le résultat du mélange à la fréquence intermédiaire est disponible sur le drain du premier transistor.

Le fonctionnement de ce circuit repose sur la modulation de la charge active du premier transistor. Le mélange est donc dû à la variation du gain du premier transistor monté en amplificateur linéaire, par la variation de la résistance constituée du transistor à effet de champ polarisé à $V_{DS} = 0$ disposé dans la branche en série avec une capacité de blocage en continu, entre la masse et le drain du premier transistor inverseur.

Le circuit connu présente plusieurs inconvénients. Tout d'abord, l'isolation du signal RF par rapport au signal OL n'est pas optimale. L'isolation du signal OL par rapport au signal de sortie IF n'est pas non plus optimale.

Ensuite, le gain de conversion du circuit est faible, car un seul étage amplificateur est utilisé.

Un but de la présente invention est de fournir un circuit dont le gain de conversion est amélioré.

Un autre but de l'invention est de fournir un circuit présentant une bonne isolation entre les différents signaux.

Mais ces avantages ne doivent pas être obtenus au détriment de la consommation du circuit. En effet, dans l'application envisagée aux récepteurs portables, la consommation doit être la plus faible possible.

Un but de la présente invention est donc de fournir un circuit qui atteint les buts précédemment cités sans augmentation de la consommation par rapport au circuit connu.

Ces buts sont atteints au moyen du circuit muni des caractéristiques du préambule, et en outre caractérisé en ce que l'amplificateur à gain variable comprend un second transistor avec une charge montés en inverseur, disposés en série avec le premier transistor et sa charge, entre cette dernière et une alimentation continue, pour que les deux transistors inverseurs partagent le même courant, le second inverseur étant commandé par la sortie du premier inverseur, et en ce que l'impédance modulée par le second signal est appliquée au point commun entre la charge du premier transistor inverseur et le second transistor inverseur, pour moduler le gain de ce dernier.

Ainsi, du fait que les deux étages amplificateurs inverseurs partagent le même courant, la consommation est très faible. Et du fait que l'amplificateur à gain variable possède deux étages, le gain de conversion est plus grand que celui du circuit connu.

Dans une mise en oeuvre, ce circuit est caractérisé en ce que la seconde fréquence est très faible devant la première fréquence, et en ce que le circuit est un amplificateur à gain variable commandé par le second signal appliqué au transistor monté en résistance variable, la sortie de cet amplificateur étant disponible à la sortie du second inverseur.

Dans une autre mise en oeuvre, ce circuit est caractérisé en ce que la seconde fréquence est celle d'un signal provenant d'un oscillateur local OL, et la première fréquence est celle d'un signal à la fréquence radio RF, et en ce que le circuit est un convertisseur de fréquence, fournissant un signal à la fréquence intermédiaire IF à la sortie du second inverseur.

Ainsi, le premier signal appliqué sur l'électrode de commande du premier transistor inverseur est bien isolé du second signal appliqué sur la commande du transistor monté en résistance variable du fait de la charge du premier inverseur.

L'isolation du signal appliqué sur la commande du transistor monté en résistance variable est aussi bien réalisée vis-à-vis du signal de sortie par le moyen du deuxième transistor inverseur.

L'invention est décrite ci-après en détail, en référence avec les figures schématiques annexées dont :

- la figure 1 représente un circuit amplificateur à gain variable monté en convertisseur de fréquences,
- la figure 2 représente un tel circuit muni d'un circuit de polarisation de grille des transistors.

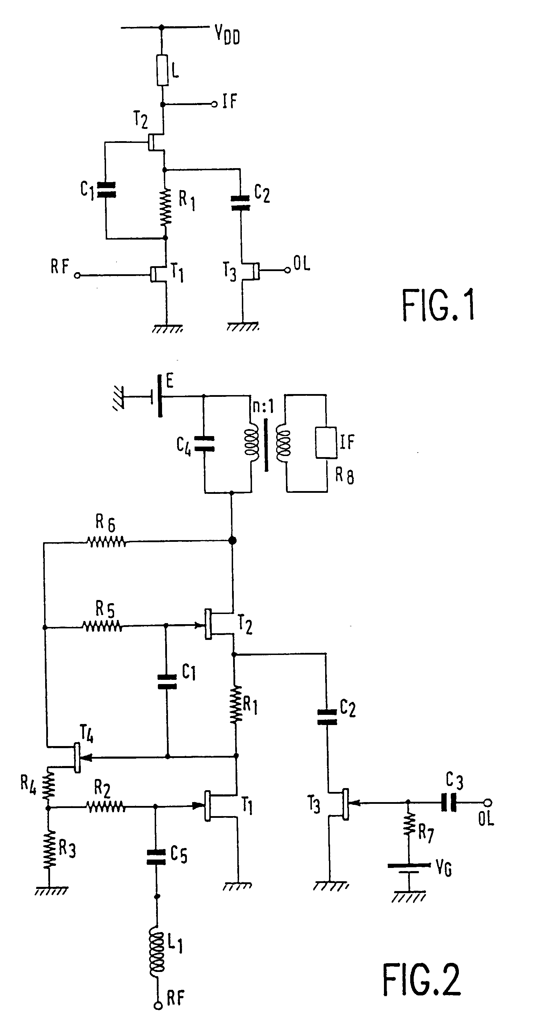

En référence avec la figure 1, un circuit intégré comprend un amplificateur à gain variable ayant un premier transistor $T_1$ monté en inverseur. A cet effet, le transistor $T_1$ est relié par son drain à une charge $R_1$, par exemple

résistive. La source du premier transistor $T_1$ est reliée à la masse, et sa grille, ou électrode de commande, reçoit un premier signal RF à une première fréquence. L'amplificateur à gain variable a un second transistor $T_2$ monté en inverseur.

Pour augmenter le gain de l'amplificateur, sans en augmenter la consommation, le second étage amplificateur inverseur partage le même courant que le premier étage amplificateur inverseur. A cet effet, la source du second transistor $T_2$ est reliée à l'extrémité de la charge $R_1$ du premier transistor $T_1$ à l'opposé de ce dernier, et le drain du second transistor $T_2$ est relié à une alimentation continue $+ V_{DD}$ à travers une charge L. Ainsi les quatre éléments, successivement le transistor $T_1$, la charge $R_1$, le transistor $T_2$, la charge L sont en série entre la masse et l'alimentation continue $+ V_{DD}$ et partagent le même courant.

Le signal de sortie du premier étage amplificateur inverseur, disponible sur le drain du premier transistor $T_1$, est reporté, à travers une capacité $C_1$ de blocage en continu, sur la grille ou électrode de commande du second transistor $T_2$ du second étage amplificateur inverseur.

La sortie est disponible sur le drain du second transitor $T_2$.

Le circuit comprend en outre une branche constituée d'un transistor $T_3$ monté en résistance variable et d'une capacité $C_2$ constituant une impédance faible et en même temps une capacité de blocage en continu.

Les éléments de cette branche sont montés en série entre la masse et la source du second transistor $T_2$ du second étage inverseur.

Le transistor $T_3$ monté en résistance variable a une borne à la masse, et l'autre borne reliée à la capacité $C_2$, elle-même reliée par son autre borne à la source du second transistor inverseur $T_2$. En continu, la tension drain-source du transistor $T_3$ est nulle, ce qui s'écrit $V_{DS} = 0$.

Dans un exemple d'utilisation du circuit de la figure 1 décrit plus haut, la tension appliquée sur la grille du transistor $T_3$ est continue ou lentement variable. On réalise alors un amplificateur à gain variable.

Dans un second exemple d'utilisation, on applique sur la grille de $T_3$ un signal OL à une seconde fréquence, provenant d'un oscillateur local. On réalise ainsi un mélangeur, ou convertisseur de fréquences. Le résultat du mélange à la fréquence intermédiaire

$$IF = |RF - OL|$$

est disponible sur le drain du second transistor $T_2$ amplificateur inverseur.

Selon la tension appliquée sur la grille du transistor $T_3$, l'impédance de la branche contenant $T_3$ et $C_2$ en série est basse ou élevée. Il en résulte que le gain du second transistor $T_2$ est respectivement élevé ou faible.

Lorsque l'impédance constituée par la mise en série

de $T_3$ et $C_2$ est basse, le gain G du circuit est celui des deux étages amplificateurs inverseurs montés en cascade, qui sont alors en source commune à la masse, par $C_2$ et $T_3$. En négligeant les capacités des transistors $T_1$ et $T_2$, le gain G s'exprime par la relation (1) :

$$G = [-g_{m1}R_1 / (1+g_{d1}R_1)] \times [-g_{m2}Z_L/(1+g_{d2}Z_L)] \quad (1)$$

relation dans laquelle :

$g_{m1}$ et $g_{d1}$    sont respectivement la transconductance et la conductance de sortie de $T_1$,

$g_{m2}$ et $g_{d2}$    sont respectivement la transconductance et la conductance de $T_2$,

$R_1$           est l'impédance de la charge $R_1$,

$Z_L$          est l'impédance de la charge L.

Lorsque l'impédance constituée par la mise en série de $C_2$ et $T_3$ est élevée, le gain G' du circuit est donné, dans les mêmes conditions de calcul par la relation (2).

$$G' = [-g_{m1}/(g_{d1}+g_{d2}/K)] \times [g_{d2}Z_L/K)] \quad (2)$$

avec

$$K = 1 + (g_{m2}+g_{d2})R_1 + g_{d2}Z_L$$

Dans le cas où la tension appliquée sur la grille de $T_3$ est continue ou lentement variable, on peut régler le gain de l'amplificateur entre les valeurs de G et G'. D'où l'utilisation en amplificateur à gain variable.

Dans le cas où le signal de commande appliqué sur la grille de $T_3$ est alternatif, on réalise un mélangeur montrant les avantages suivants :

A) Le gain de conversion est élevé, notamment du fait que le gain maximum G du circuit en tant qu'amplificateur est élevé, d'une valeur supérieure ou égale à 20 dB, et du fait que la dynamique de variation du gain sous l'effet de la tension de commande appliquée à $T_3$ est élevée de l'ordre de 25 dB. Ce gain est beaucoup plus élevé que dans le circuit connu.

En effet, dans le circuit de la figure 1 décrit plus haut, c'est le gain du transistor $T_2$ qui est modulé, et non une charge comme cela était le cas dans le circuit de la demande de brevet EP 0 223 287 citée au titre d'état de la technique. Cela ressort de l'examen des deux relations G et G'. Ces relations montrent que le gain est obtenu par la participation de deux termes représentant respectivement le gain du premier étage inverseur, et le gain du second étage inverseur. Dans le cas où l'impédance de la branche est faible, les deux termes ont une expression fonctionnelle de sorte que G (1) est le gain des deux inverseurs. Dans le cas où l'impédance de la branche est élevée, le gain du premier étage inverseur est peu modifié, alors que le gain du second étage inverseur est très modifié, comme il ressort de G' (2).

B) L'isolation entre le signal OL appliqué sur la grille du transistor monté en résistance variable $T_3$ et le signal RF appliqué sur la grille du premier transistor inverseur $T_1$, est forte. En effet, cette isolation est réalisée par la forte impédance constituée par la mise en série de la capacité grille-drain du premier transistor $T_1$ et de sa résistance de charge $R_1$. L'isolation est donc meilleure que dans le circuit connu.

C) L'isolation entre le signal OL appliqué sur la grille de $T_3$ et le signal à la fréquence intermédiaire IF disponible sur le drain du second transistor inverseur $T_2$ est forte. En effet, le transistor $T_2$ n'a pas de gain vis-à-vis du signal OL appliqué sur sa source. L'isolation est donc meilleure que dans le circuit connu.

D) Le facteur de bruit du circuit est très bas contrairement à ce qui était le cas dans le circuit connu. Un faible facteur de bruit est obtenu du fait que le transistor $T_1$, en tant qu'amplificateur pour le premier signal RF, ne voit pas son régime perturbé par le mélange. Ce transistor $T_1$ reste en permanence dans des conditions de fonctionnement faible bruit et le signal RF est constamment amplifié.

E) La consommation est faible. En effet, les transistors $T_1$ et $T_2$ partagent le même courant. Le transistor $T_3$ monté en résistance variable ne consomme aucun courant autre que le courant très faible consommé par la grille.

F) Le gain en puissance est élevé. Ce paramètre distingue particulièrement le circuit selon l'invention du circuit connu.

**EXEMPLE DE REALISATION**

La figure 2 montre un exemple de mise en oeuvre du circuit schématique de la figure 1. Ce circuit est réalisé au moyen de transistors à effet de champ en arséniure de gallium (GaAs) à enrichissement, c'est-à-dire normalement bloqués en l'absence de tension grille-source. Les trois transistors $T_1$, $T_2$, $T_3$ sont choisis de taille identique.

Les transistors $T_1$ et $T_2$ des deux étages inverseurs ont une polarisation de grille réalisée au moyen du circuit constitué par le transistor $T_4$ et le pont de résistances $R_2$, $R_3$, $R_4$ d'une part et $R_5$, $R_6$ d'autre part.

Le transistor $T_3$ est polarisé au travers d'une résistance $R_7$ par une seconde tension d'alimentation $V_G$. Cette tension d'alimentation $V_G$ peut être générée à partir d'une tension d'alimentation principale positive E.

Le premier signal RF à la fréquence radio, est appliqué sur la grille du premier transistor inverseur $T_1$, par le moyen d'un circuit constitué d'une self $L_1$ et d'une capacité $C_5$ permettant de réaliser l'adaptation à l'impédance 50 Ω standard, et l'isolation en continu.

Le second signal OL est appliqué sur la grille du transistor $T_3$ à travers la capacité $C_3$ d'isolation en continu.

Le signal IF résultat du mélange est prélevé sur le drain du second transistor $T_2$ au primaire d'un transformateur d'impédance accordé à la fréquence souhaitée. L'accord est obtenu au moyen de la capacité $C_4$. Le signal est recueilli aux bornes de la résistance $R_8$ au secondaire du transformateur.

Dans cet exemple, les fréquences utilisées sont :

$$f_{OL} = 2 \text{ GHz}$$

$$f_{RF} = 1,8 \text{ GHz}$$

$$f_{IF} = 200 \text{ MHz}$$

Le gain de conversion en puissance est $\simeq 10$ dB.

Le niveau du signal OL retrouvé à l'entrée RF est - 50 dB.

La consommation est $\simeq 5$ mA pour $V_{DD} = 4$ V.

Ce circuit trouve son application dans tout récepteur où l'on recherche une faible consommation, un faible bruit, et une bonne isolation du signal OL. Typiquement, on utilise ce circuit pour réaliser des émetteurs/récepteurs portables tels que des téléphones portables pour la téléphonie cellulaire dans le domaine 900 MHz à 1800 MHz.

**Revendications**

1. Circuit intégré comprenant un amplificateur à gain variable ayant un premier transistor avec une charge montés en inverseur, commandé par un premier signal à une première fréquence, et ayant en outre une branche, formée d'une capacité en série avec un transistor monté en résistance variable, dont l'impédance est modulée par un second signal à une seconde fréquence, caractérisé en ce que l'amplificateur à gain variable comprend un second transistor avec une charge montés en inverseur, disposés en série avec le premier transistor et sa charge, entre cette dernière et une alimentation continue, pour que les deux transistors inverseurs partagent le même courant, le second inverseur étant commandé par la sortie du premier inverseur, et en ce que l'impédance modulée par le second signal est appliquée au point commun entre la charge du premier transistor inverseur et le second transistor inverseur, pour moduler le gain de ce dernier.

**2.** Circuit selon la revendication 1, caractérisé en ce que la seconde fréquence est très faible devant la première fréquence, et en ce que le circuit est un amplificateur à gain variable commandé par le signal appliqué au transistor monté en résistance variable, la sortie de cet amplificateur étant disponible à la sortie du second inverseur.

**3.** Dispositif selon la revendication 1, caractérisé en ce que la seconde fréquence est celle d'un signal provenant d'un oscillateur local OL, et la première fréquence est celle d'un signal à la fréquence radio RF, et en ce que le circuit est un convertisseur de fréquences, fournissant un signal à la fréquence intermédiaire IF à la sortie du second inverseur.

**4.** Dispositif selon l'une des revendications précédentes, caractérisé en ce qu'il est réalisé au moyen de transistors à effet de champ en arséniure de gallium.

**5.** Dispositif selon la revendication 4, caractérisé en ce que les trois transistors du circuit sont de taille identique et sont du type dit à enrichissement c'est-à-dire bloqué en l'absence de signal grille-source.

**6.** Utilisation d'un dispositif selon l'une des revendications 1, ou 3 à 5 pour réaliser un récepteur du type dit mobile.

**Patentansprüche**

**1.** Integrierte Schaltung mit einem Verstärker mit variabler Verstärkung, die einen von einem ersten Signal mit einer ersten Frequenz gesteuerten und als Stromwender geschalteten ersten Transistor mit einer Last und außerdem einen Zweig umfaßt, der aus einer Kapazität gebildet wird, die in Reihe mit einem als variablen Widerstand geschalteten Transistor geschaltet ist und deren Impedanz von einem zweiten Signal mit einer zweiten Frequenz moduliert wird, dadurch gekennzeichnet, daß der Verstärker mit variabler Verstärkung einen als Stromwender geschalteten und in Reihe mit dem ersten Transistor und seiner Last zwischen dieser Last und einer Gleichstromquelle angebrachten zweiten Transistor mit einer Last umfaßt, damit die beiden Stromwendertransistoren sich den gleichen Strom teilen, wobei der zweite Stromwender durch das Ausgangssignal des ersten Stromwenders gesteuert wird, und daß die vom zweiten Siganl modulierte Impedanz dem gemeinsamen Punkt zwischen der Last des ersten Stromwendertransistors und des zweiten Stromwendertransistors zugeführt wird, um die Verstärkung des letztgenannten zu modulieren.

**2.** Schaltung nach Anspruch 1, <u>dadurch gekennzeichnet</u>, daß die zweite Frequenz gegenüber der ersten Frequenz sehr niedrig ist und daß die Schaltung einen Verstärker mit variabler Verstärkung darstellt, der durch das zweite Signal gesteuert wird, das dem als variablen Widerstand geschalteten Transistor zugeführt wird, wobei das Ausgangssignal dieses Verstärkers am Ausgang des zweiten Stromwenders zur Verfügung steht.

**3.** Anordnung nach Anspruch 1, <u>dadurch gekennzeichnet</u>, daß die zweite Frequenz die eines Signals ist, das aus einem lokalen Oszillator OL stammt, und die erste Frequenz die eines Signals mit der Funkfrequenz RF ist, und daß die Schaltung einen Frequenzumsetzer darstellt, der ein Signal mit der Zwischenfrequenz IF am Ausgang des zweiten Stromwenders liefert.

**4.** Anordnung nach einem der vorgenannten Ansprüche, <u>dadurch gekennzeichnet</u>, daß sie mit Hilfe von Feldeffekttransistoren aus Galliumarsenid verwirklicht werden.

**5.** Anordnung nach Anspruch 4, <u>dadurch gekennzeichnet</u>, daß die drei Transistoren der Schaltung vom gleichen Typ sind und dem als Anreicherungstyp bezeichneten Typ entsprechen, das heißt gesperrt sind, wenn kein Gate-Source-Signal anliegt.

**6.** Verwendung einer Anordnung nach einem der Ansprüche 1 oder 3 bis 5 zur Verwirklichung eines als mobil bezeichneten Empfängers.

**Claims**

**1.** An integrated circuit comprising a variable-gain amplifier having a first transistor with a first load arranged as an inverter, which first transistor is controlled by a first signal of a first frequency, and having a branch comprising a capacitance in series with another transistor arranged as a variable resistance, the impedance of said other transistor being modulated by a second signal of a second frequency, characterised in that the variable-gain amplifier comprises a second transistor with a load arranged as an inverter, which second transistor and its load are arranged in series with the first transistor and its load between the latter and a d.c. supply, in such a way that the two inverter transistors share the same current, the second inverter being controlled by the output of the first inverter, and the impedance which is modulated by the second signal is applied to the node between the load of the first inverter transistor and the second inverter transistor in order to modulate the gain of the latter.

2. A circuit as claimed in Claim 1, characterised in that the second frequency is very low in comparison with the first frequency, and the circuit is a variable-gain amplifier controlled by the signal applied to the transistor arranged as a variable resistor, the output of said amplifier being available at the output of the second inverter.

3. A circuit as claimed in Claim 1, characterised in that the second frequency is that of a signal from a local oscillator OL, and the first frequency is that of a radio-frequency signal RF, and the circuit is a frequency converter which supplies an intermediate-frequency signal IF to the output of the second inverter.

4. A circuit as claimed in any one of the preceding Claims, characterised in that it is realized by means of gallium arsenide field-effect transistors.

5. A circuit as claimed in Claim 4, characterised in that the three transistors have identical dimensions and are of the enhancement type, i.e. cut off in the absence of a gate-source signal.

6. Use of a circuit as claimed in any one of the Claims 1, or 3 to 5 for realizing a receiver of the mobile type.

FIG.1

FIG.2

7